Europäisches Patentamt

European Patent Office

Office européen des brevets

(11) Publication number: **0 229 040 B1**

# EUROPEAN PATENT SPECIFICATION

(45) Date of publication of patent specification: **17.06.92**   (51) Int. Cl.⁵: **H01L 31/11**, H01L 31/108

(21) Application number: **87400025.0**

(22) Date of filing: **08.01.87**

(54) **Metal-semiconductor-metal photodiode.**

(30) Priority: **08.01.86 JP 776/86**

(43) Date of publication of application:
**15.07.87 Bulletin 87/29**

(45) Publication of the grant of the patent:
**17.06.92 Bulletin 92/25**

(84) Designated Contracting States:
**DE FR GB**

(56) References cited:
**EP-A- 0 042 498**
**EP-A- 0 063 421**
**GB-A- 1 535 367**
**US-A- 4 532 373**

**JAPANESE JOURNAL OF APPLIED PHYSICS
vol. 19, Suppl. 19-2, 1980, pages 137-141,
Tokyo, Japan; Y. KUWANO et al.:
"Amorphous Si Photovoltaic Cells and Cell
Module (Integrated Cell Module)".**

**IEEE JOURNAL OF OUANTUM ELECTRONICS
OE-22 no. 7, July 1986, pages 1073-1077, New
York, USA; M. ITO et al.: "Low Dark Current
GaAs Metal-Semiconductor-Metal (MSM)
Photodiodes Using WSIx Contacts".**

(73) Proprietor: **FUJITSU LIMITED**
**1015, Kamikodanaka Nakahara-ku
Kawasaki-shi Kanagawa 211(JP)**

(72) Inventor: **Ito, Masanori**
**3-8-19, Minamidai
Sagamihara-shi Kanagawa, 228(JP)**

(74) Representative: **Descourtieux, Philippe et al
CABINET BEAU de LOMENIE 55 rue
d'Amsterdam
F-75008 Paris(FR)**

## Description

The present invention generally relates to metal-semiconductor-metal photodiodes, and more particularly to a metal-semiconductor-metal photodiode in which dark current is minimized.

Generally, a metal-semiconductor-metal (MSM) photodiode is suited for forming a semiconductor device by integration with transistors. The present inventor has previously proposed in Japanese Patent Application No. 60-111376 an MSM photodiode in which dark current is reduced. According to the previously proposed MSM photodiode, a tungsten silicide (WSi$_x$) is used as the material constituting the electrodes of the MSM photodiode.

Previously proposed MSM photodiode is advantageous in that the dark current is reduced and a signal reception system can be obtained which can receive signals with a satisfactory signal-to-noise ratio. However, the same electrode material is used for both anode and cathode electrodes of the MSM photodiode, and compromise is necessary when selecting the electrode material. In other words, when a Schottky barrier height from a conduction band is high, the injection electrons are in small numbers but the injection holes are in large numbers. On the other hand, when the Schottky barrier height from the conduction band is low, the injection holes are in small numbers but the injection electrons are in large numbers. Hence, WSi$_x$ is used as the electrode material for both the anode and the cathode electrodes of the MSM photodiode. However, it would be more advantageous if it were possible to further reduce the dark current.

Accordingly, it is a general object of the present invention to provide a novel and useful MSM photodiode in which the above described demands are satisfied.

According to the present invention, an MSM photodiode is provided which comprises a semiconductor layer, a cathode electrode formed on the semiconductor layer and made of a first electrode material having a Schottky barrier height $\phi_{bn}$ from the conduction band satisfying the relation $\phi_{bn} >$ Eg/2, where Eg denotes the energy band gap of the semiconductor material forming said layer, and an anode electrode formed on the semiconductor layer and made of a second electrode material different from the first electrode material and having a Schottky barrier height $\phi_{bp}$ from the valence band satisfying the relation $\phi_{bp} >$ Eg/2, a bias voltage being applied between said electrodes.

With the MSM photodiode of the present invention, it is possible to obtain a large current upon reception of an optical signal. Hence, it is possible to greatly reduce the dark current and to obtain a signal reception system capable of receiving signals with a satisfactory signal-to-noise ratio.

At least one of the cathode electrode and the anode electrode may have a relatively small film thickness and be provided with an indium tin oxide (ITO) or indium oxide (InO$_x$) layer formed thereon, allowing the photodiode to show an improved sensitivity.

Other objects and further features of the present invention will be apparent from the following detailed description when read in conjunction with the accompanying drawings.

Fig. 1 shows the relationships between the dark current and the barrier height;

Fig.2 is a diagram showing the energy band of a previously proposed MSM photodiode;

Fig.3 is a plan view showing an essential part of an embodiment of a MSM photodiode according to the present invention;

Fig.4 is a cross-sectional view of the MSM photodiode along a line IV-IV in Fig.3;

Fig.5 is a diagram showing the energy band of the MSM photodiode shown in Figs.3 and 4;

Fig.6 is a cross sectional view showing an application of the MSM photodiode according to the present invention; and

Fig.7 is a cross-sectional view showing another embodiment of a MSM photodiode according to the present invention.

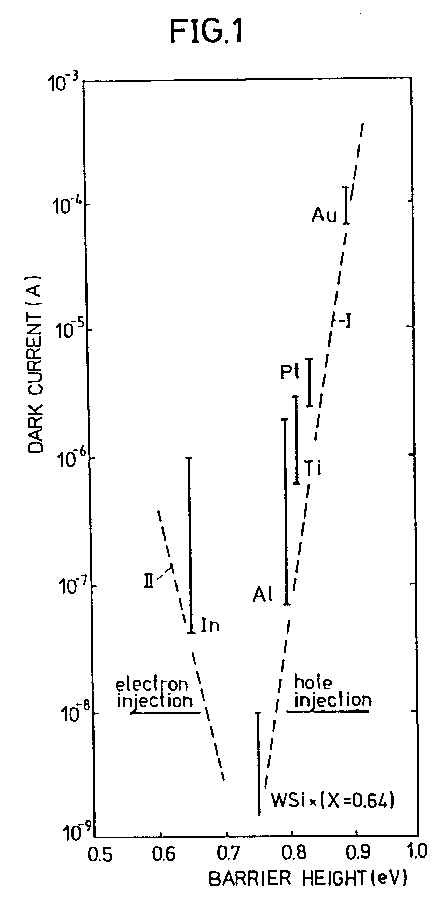

In the above-mentioned previously proposed MSM photodiode, WSi$_x$ is used as the material constituting the electrodes. Fig.1 shows the relationships between the dark current and the Schottky barrier height which are essentially experimental results obtained when the previously proposed MSM photodiode was devised. In Fig.1, the abscissa indicates the barrier height dependent on the metal constituting the electrodes of the MSM photodiode, and the ordinate indicates the dark current in the MSM photodiode. Furthermore, the Schottky barrier height is shown for the case where each metal electrode is formed on an n-type gallium arsenide (GaAs) layer, and the bias voltage is 10 volts. As may be seen from Fig.1, the dark current has the smallest value when WSi$_x$ is used as the electrode material. In Fig.1, phantom lines I and II indicate characteristics which are obtained by connecting minimum values of the dark current for the various electrode materials.

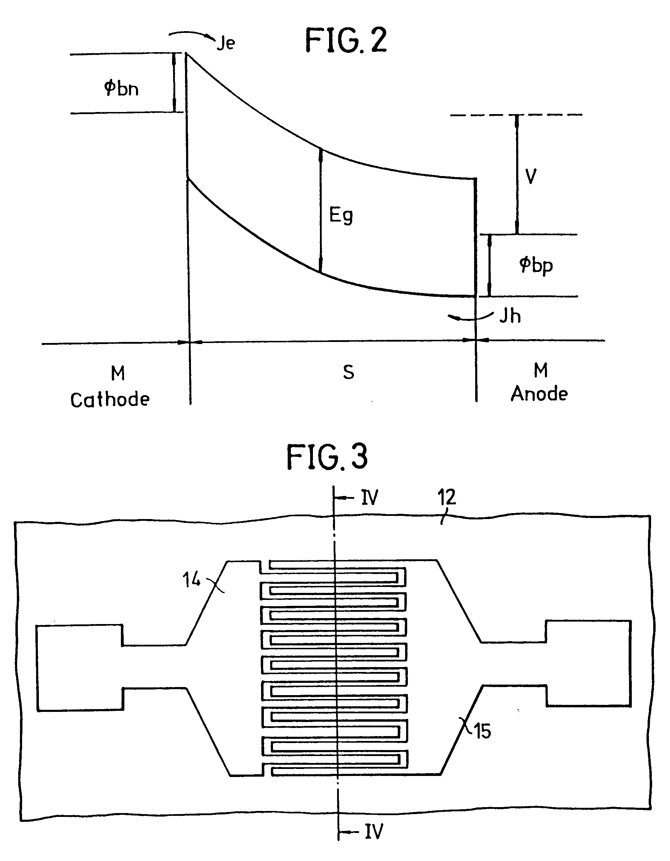

Fig.2 shows the energy band diagram of the previously proposed MSM photodiode. In Fig.2, M denotes a metal electrode, S denotes a semiconductor layer, V denotes a bias voltage, $\phi_{bn}$ denotes a Schottky barrier height from a conduction band, $\phi_{bp}$ denotes a Schottky barrier height from a valence band, $j_e$ denotes injection electrons and $j_h$ denotes injection holes. When the barrier height $\phi_{bn}$ is high, the injection electrons $j_e$ are in small numbers, but the injection holes $j_h$ are in large

numbers because $\phi_{bp} = Eg - \phi_{bn'}$ where Eg denotes the energy band gap. On the other hand, when the barrier height $\phi_{bn}$ is low, the injection holes $j_h$ are in small numbers but the injection electrons $j_e$ are in large numbers.

Accordingly, best results can be obtained when $\phi_{bn} \fallingdotseq Eg/2$, and $WSi_x$ is a metal which satisfies this condition. By using $WSi_x$ as the electrode material of the MSM photodiode, it is thus possible to considerably reduce the dark current compared to the case where a metal such as aluminum (A$\ell$) is used as the electrode material.

The present invention uses different electrode materials for the anode and the cathode electrodes of the MSM photodiode so as to further reduce the dark current compared to the previously proposed MSM photodiode.

Generally, the injection electrons $j_e$ and the injection holes $j_h$ in the MSM photodiode can be described by the following relations, where An* and Ap* denote the Richardson's constants, T denotes the absolute temperature, q denotes the electron charge, k denotes the Boltzmann's constant, and $\Delta\phi_{bn}$ and $\Delta\phi_{bp}$ denote the deviation in the respective barrier heights $\phi_{bn}$ and $\phi_{bp}$. The terms $e^{q\Delta\phi bn/kT}$ and $e^{q\Delta\phi bp/kT}$ occur due to the decrease in the barrier heights when the bias voltage changes, and have virtually no effects.

$$j_e = An^* \, T^2 e^{-q\phi bn/kT} . e^{q\Delta\phi bn/kT}$$
$$j_h = Ap^* \, T^2 e^{-q\phi bp/kT} . e^{q\Delta\phi bp/kT}$$

As may be seen from the above relations, in order to increase the injection electrons or the injection holes to reduce the dark current, the barrier heights $\phi_{bn}$ and $\phi_{bp}$ should be made high. In the previously proposed MSM photodiode, the barrier height is approximately Eg/2, and in order to increase the injection electrons or the injection holes compared to this case, the barrier heights $\phi_{bn}$ and $\phi_{bp}$ must satisfy $\phi_{bn} > Eg/2$ and $\phi_{bp} > Eg/2$. Therefore, in the MSM photodiode according to the present invention, the cathode and the anode electrodes of the MSM photodiode are made of such mutually different electrode materials (for example, Au and In) that the cathode electrode has a barrier height $\phi_{bn}$ satisfying $\phi_{bn} > Eg/2$ and the anode electrode has a barrier height $\phi_{bp}$ satisfying $\phi_{bp} > Eg/2$. According to the MSM photodiode of the present invention, since each of the barrier heights $\phi_{bn}$ and $\phi_{bp}$ is high enough to avoid a thermal emission of carriers like $j_e$ and $j_h$, it is possible to greatly reduce the dark current. On the other hand, since the barrier heights $\phi_{bn}$ and $\phi_{bp}$ have little relationship to the produced current when the MSM photodiode receives an optical signal, it is possible to reduce the dark current without reducing the current responsive to the optical signal. Therefore, it is possible to obtain a signal reception system for receiving signals with a satisfactory signal-to-noise ratio.

In order to make the barrier height $\phi_{bn}$ on the cathode side of the MSM photodiode greater than Eg/2, a material such as gold (Au), platinum (Pt), titanium (Ti) and A$\ell$ is used as the electrode material constituting the cathode electrode. On the other hand, in order to make the barrier height $\phi_{bp}$ on the anode side of the MSM photodiode greater than Eg/2, a material such as indium (In) and $WSi_x$ is used as the electrode material constituting the anode electrode, where x is in the range of 0.5 to 0.8, and x = 0.64, for example.

Fig.3 is a plan view showing an essential part of an embodiment of the MSM photodiode according to the present invention, said photodiode comprising a GaAs active layer 12, a cathode electrode 14 made of Au, and an anode electrode 15 made of In.

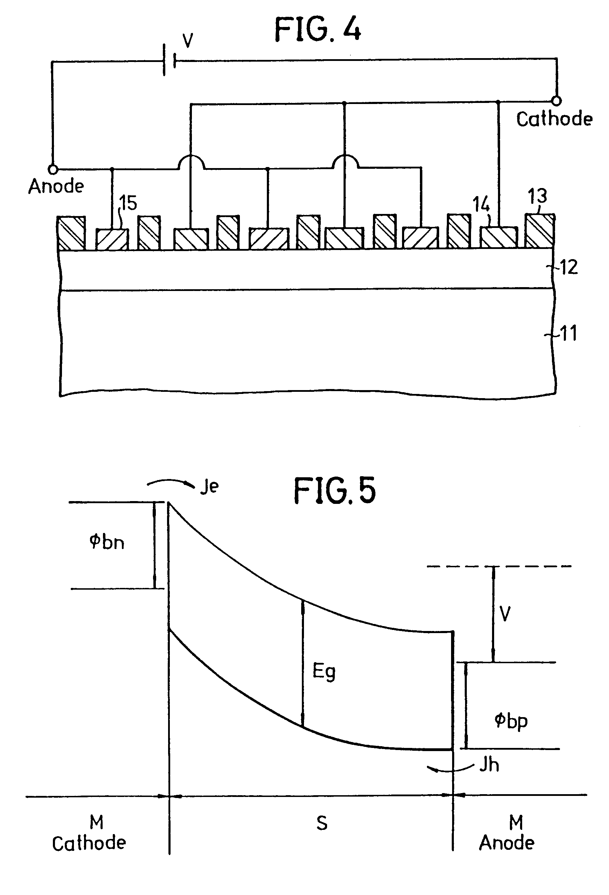

Fig.4 is a cross-sectional view of the MSM photodiode showing the active GaAs layer 12 formed on a semi-insulating GaAs substrate 11, and a silicon nitride (SiN) layer 13 formed on the active GaAs layer 12. A bias voltage V is applied across the anode and the cathode as shown. In the MSM photodiode shown in Figs.3 and 4, the light impinges on portions between the cathode and anode electrodes 14 and 15 arranged in the form of the teeth of a comb, the teeth portions of the cathode electrode alternating with the teeth portions of the anode electrode.

Fig.5 shows the energy band diagram of the MSM photodiode shown in Figs.3 and 4. The cathode electrode has a barrier height $\phi_{bn}$ satisfying $\phi_{bn} > Eg/2$ and the anode electrode has a barrier height $\phi_{bp}$ satisfying $\phi_{bp} > Eg/2$. A bias voltage V is applied across the anode and the cathode as shown. Accordingly, the current which flows when the MSM photodiode receives light is large, and the dark current is quite small. By way of indication, the dark current in the MSM photodiode according to the present invention can be reduced to at least 1/10 the dark current of the previously proposed MSM photodiode.

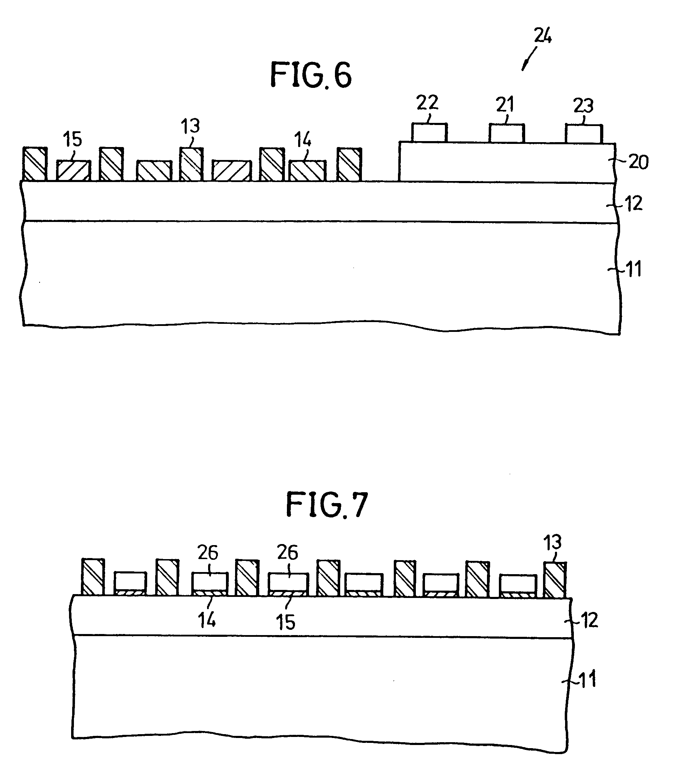

Fig.6 shows a combination of the MSM photodiode shown in Figs.3 and 4 with a transistor such as a metal semi-conductor field effect transistor (MESFET) to constitute a semiconductor device. In Fig.6, those parts which are the same as those corresponding parts in Fig.4 are designated by the same reference numerals, and description thereof will be omitted. An additional GaAs active layer 20 is formed on the GaAs active layer 12, and a Schottky gate electrode 21, an ohmic contact source 22 and an ohmic contact drain 23 are formed on the additional GaAs active layer 20. In this case, the GaAs active layer 12 in a MESFET portion 24 acts as a buffer layer.

Fig.7 shows another embodiment of the MSM photodiode according to the present invention. In Fig.7, those parts which are the same as those corresponding parts in Fig.4 are designated by the same reference numerals, and description thereof will be omitted. In the embodiment of Fig.7, the cathode and anode electrodes 14 and 15 have a small film thickness in the range of 5nm to 10 nm, and an additional layer 26 which is made of indium tin oxide (ITO) or indium oxide (InO$_x$) and has a film thickness in the order of 200 nm is formed on the cathode and anode electrodes 14 and 15, so as to effectively increase the sensitivity of the MSM photodiode. As in the case of the embodiment described before, the dark current can be minimized in the present embodiment. Although it is more desirable to provide the additional layer 26 on both the cathode and anode electrodes 14 and 15, the additional layer 26 may be formed on only one of the cathode and anode electrodes 14 and 15.

## Claims

1. A metal-semiconductor- metal photodiode comprising a semiconductor layer (12) and a cathode electrode (14) and an anode electrode (15) formed on the semiconductor layer, a bias voltage(V) being applied between said electrodes characterized in that:

   the cathode electrode (14) is made of a first electrode material having a Schottky barrier height $\phi_{bn}$ from the conduction band satisfying a relation $\phi_{bn} > Eg/2$, where Eg denotes the energy band gap of the semiconductor material forming said layer (12)

   the anode electrode (15) is made of a second electrode material different from said first electrode material and having a Schottky barrier height $\phi_{bp}$ from the valence band satisfying a relation $\phi_{bp} > Eg/2$.

2. A metal-semiconductor-metal photodiode as claimed in claim 1 in which said first electrode material is selected from a group of gold, platinum, titanium and aluminum, and said second electrode material is selected from a group of indium and tungsten silicide

3. A metal-semiconductor-metal photodiode as claimed in claim 1 or 2 in which said second electrode material is WSi$_x$, where X is in a range of 0.5 to 0.8.

4. A metal-semiconductor-metal photodiode as claimed in any one of claims 1 to 3 which further comprises an additional layer (26) formed on at least one of said cathode electrode (14) and said anode electrode (15), said additional layer being made of a material selected from a group of indium tin oxide and indium oxide.

5. A metal-semiconductor-metal photodiode as claimed in claim 4 in which said additional layer (26) has a film thickness in the order of 200 nm, and said cathode electrode (14) and/or said anode electrode (15) having said additional layer formed thereon has a film thickness in a range of 5 nm to 10 nm.

6. A metal-semiconductor-metal photodiode as claimed in any one of claims 1 to 5 in which said semiconductor layer (12) is an active layer, said active layer being formed on a semi-insulating substrate (11).

7. A metal-semiconductor-metal photodiode as claimed in claim 6 in which said active layer (12) is made of gallium arsenide.

8. A metal-semiconductor-metal photodiode as claimed in claim 6 or 7, in which said cathode electrode (14) and said anode electrode (15) are arranged on said active layer (12) in the form of teeth of a comb so that teeth portions of said cathode electrode and said anode electrode alternate.

## Revendications

1. Photodiode métal-semiconducteur-métal comprenant une couche semiconductrice (12) ainsi qu'une électrode de cathode (14) et une électrode d'anode (15) formées sur la couche semiconductrice, une tension de polarisation (V) étant appliquée entre lesdites électrodes, caractérisée en ce que :

   l'électrode de cathode (14) est faite d'un premier matériau d'électrode qui possède une hauteur de barrière de Schottky $\phi_{bn}$, par rapport à la bande de conduction, satisfaisant la relation $\phi_{bn} > Eg/2$, où Eg désigne la bande interdite d'énergie du matériau semiconducteur formant ladite couche (12), et

   l'électrode d'anode (15) est faite d'un deuxième matériau d'électrode, qui diffère dudit premier matériau d'électrode et possède une hauteur de barrière de Schottky $\phi_{bp}$, par rapport à la bande de valence, satisfaisant la relation $\phi_{bp} > Eg/2$.

2. Photodiode métal-semiconducteur-métal selon la revendication 1, dans laquelle ledit premier matériau d'électrode est choisi dans le groupe formé de l'or, du platine, du titane et de l'aluminium, et ledit deuxième matériau d'électrode est choisi dans le groupe formé de l'indium et du siliciure de tungstène.

3. Photodiode métal-semiconducteur-métal selon la revendication 1 ou 2, dans laquelle ledit deuxième matériau d'électrode est WSi$_x$, où x est compris dans l'intervalle de 0,5 à 0,8.

4. Photodiode métal-semiconducteur-métal selon l'une quelconque des revendications 1 à 3, qui comprend en outre une couche supplémentaire (26) formée sur au moins une desdites électrodes de cathode (14) et d'anode (15), ladite couche supplémentaire étant faite d'un matériau choisi dans le groupe formé de l'oxyde d'indium et d'étain et de l'oxyde d'indium.

5. Photodiode métal-semiconducteur-métal selon la revendication 4, dans laquelle ladite couche supplémentaire (26) possède une épaisseur de pellicule de l'ordre de 200 nm, et ladite électrode de cathode (14) et, ou bien, ladite électrode d'anode (15) sur laquelle, ou sur lesquelles, ladite couche supplémentaire est formée possèdent une épaisseur de pellicule comprise dans l'intervalle de 5 nm à 10 nm.

6. Photodiode métal-semiconducteur-métal selon l'une quelconque des revendications 1 à 5, dans laquelle ladite couche semiconductrice (12) est une couche active, ladite couche active étant formée sur un substrat semi-isolant (11).

7. Photodiode métal-semiconducteur-métal selon la revendication 6, dans laquelle ladite couche active (12) est faite d'arséniure de gallium.

8. Photodiode métal-semiconducteur-métal selon la revendication 6 ou 7, dans laquelle ladite électrode de cathode (14) et ladite électrode d'anode (15) sont disposées en dents de peigne sur ladite couche active (12) de façon que les parties dents de ladite électrode de cathode et de ladite électrode d'anode alternent.

**Patentansprüche**

1. Eine Metall-Halbleiter-Metall-Photodiode mit einer Halbleiterschicht (12) und einer Kathodenelektrode (14) und einer Anodenelektrode (15), welche sich auf der Halbleiterschicht befinden, wobei eine Vorspannung (V) zwischen den genannten Elektroden angelegt wird, dadurch gekennzeichnet, daß:

die Kathodenelektrode (14) aus einem ersten Elektrodenmaterial besteht, welches eine Schottky-Barrierenhöhe $\phi_{bn}$ aus dem Leitungsband hat, welche einer Beziehung $\phi_{bn} > Eg/2$ genügt, wobei Eg die Energiebandlücke des die genannte Schicht (12) bildenden Halbleitermaterials bezeichnet,

die Anodenelektrode (15) aus einem zweiten Elektrodenmaterial besteht, welches sich vom genannten ersten Elektrodenmaterial unterscheidet, und eine Schottky-Barrierenhöhe $\phi_{bp}$ aus dem Valenzband hat, welche einer Beziehung $\phi_{bp} > Eg/2$ genügt.

2. Eine Metall-Halbleiter-Metall-Photodiode nach Anspruch 1, bei welcher das genannte erste Elektrodenmaterial aus einer Gruppe von Gold, Platin, Titan und Aluminium ausgewählt ist, und das genannte zweite Elektrodenmaterial aus einer Gruppe von Indium- und Wolframsilizid ausgewählt ist.

3. Eine Metall-Halbleiter-Metall-Photodiode nach Anspruch 1 oder 2, bei welcher das genannte zweite Elektrodenmaterial WSi$_x$ ist, wobei x in einem Bereich von 0,5 bis 0,8 liegt.

4. Eine Metall-Halbleiter-Metall-Photodiode nach irgendeinem der Ansprüche 1 bis 3, welche ferner eine zusätzliche Schicht (26) umfaßt, die sich auf mindestens einer der genannten Kathodenelektrode (14) und der genannten Anodenelektrode (15) befindet, wobei die genannte zusätzliche Schicht aus einem Material besteht, welches aus einer Gruppe von Indium-Zinn-Oxid und Indium-Oxid ausgewählt ist.

5. Eine Metall-Halbleiter-Metall-Photodiode nach Anspruch 4, bei welcher die genannte zusätzliche Schicht (26) eine Schichtdicke in der Größenordnung von 200 nm hat, und die genannte Kathodenelektrode (14) und/oder die genannte Anodenelektrode (15), auf denen sich die genannte zusätzliche Schicht befindet, eine Schichtdicke in einer Größenordnung von 5 nm bis 10 nm hat.

6. Eine Metall-Halbleiter-Metall Photodiode nach irgendeinem der Ansprüche 1 bis 5, bei welcher die genannte Halbleiterschicht (12) eine aktive Schicht ist, wobei die genannte aktive Schicht auf einem halbisolierenden Substrat (11) gebildet ist.

7. Eine Metall-Halbleiter-Metall-Photodiode nach Anspruch 6, bei welcher die genannte aktive Schicht (12) aus Galliumarsenid besteht.

8. Eine Metall-Halbleiter-Metall-Photodiode nach Anspruch 6 oder 7, bei welcher die genannte Kathodenelektrode (14) und die genannte Anodenelektrode (15) auf der genannten aktiven Schicht (12) kammzinkenförmig angeordnet sind, so daß sich die Zinkenteile der genannten Kathodenelektrode und der genannten Anodenelektrode abwechseln.

# FIG.1

# FIG.2

$\phi bn$

Je

$\phi bp$

Eg

V

Jh

M
Cathode

S

M
Anode

# FIG.3

IV

12

14

15

IV

8

## FIG. 4

## FIG.5

# FIG.6

# FIG.7